# EUROPÄISCHE PATENTSCHRIFT

(11) **EP 1 927 005 B1**
(45) Veröffentlichungstag und Bekanntmachung des Hinweises auf die Patenterteilung: **21.07.2010**
(21) Anmeldenummer: 06791971.2
(22) Anmeldetag: 11.09.2006
(51) Int. Cl.: G01R 33/02

(54) **EINRICHTUNG ZUR BESTIMMUNG DER STÄRKE DES MAGNETFELDES EINES ELEKTROMAGNETEN**
DEVICE FOR DETERMINING THE STRENGTH OF THE MAGNETIC FIELD OF AN ELECTROMAGNET
DISPOSITIF PERMETTANT DE DETERMINER L'INTENSITE DU CHAMP MAGNETIQUE D'UN ELECTROAIMANT

(30) Priorität: 23.09.2005 DE 102005045537
(43) Veröffentlichungstag der Anmeldung: 04.06.2008
(73) Patentinhaber: Deutsches Elektronen-Synchrotron DESY, 22607 Hamburg (DE)
(72) Erfinder: WERNER, Matthias, 22549 Hamburg (DE)
(74) Vertreter: UEXKÜLL & STOLBERG
(86) Internationale Anmeldenummer: PCT/EP2006/008823
(87) Internationale Veröffentlichungsnummer: WO 2007/036296

(56) Entgegenhaltungen:
- EP-A2- 0 257 371
- DE-B1- 2 916 289
- US-A- 5 668 470

## Beschreibung

Die vorliegende Erfindung betrifft eine Einrichtung und ein Verfahren zur Bestimmung der Magnetfeldstärke eines Elektromagneten.

Die Bestimmung der Stärke des Magnetfeldes eines Elektromagneten kann durch Messen des Stromes erfolgen, der durch den Magneten fließt, da dieser ein direktes Maß für das erzeugte Magnetfeld ist, wobei dies bei einem Magneten mit einem Eisenkern allerdings u.a. durch Hysterese- und Sättigungseffekte verfälscht ist. Bei an Beschleunigeranlagen verwendeten Elektromagneten treten häufig sehr große Ströme auf, sodass zur Messung das um eine Zuleitung auftretende Magnetfeld genutzt wird. Dazu sind aus dem Stand der Technik sogenannte DCCTs (Direct Current Current Transformer) bekannt, wie sie beispielsweise die WO 2005/052605 offenbart. Alternativ ist es auch möglich, das Magnetfeld in dem Magneten direkt mit Hilfe einer Hall-Sonde zu messen.

Derartige Messeinrichtungen haben jedoch den Nachteil, dass auftretende Veränderungen des Stromes bzw. des Magnetfeldes erst nach vergleichsweise langer Zeit im Ausgangssignal erkennbar sind. Damit kann auf Veränderungen im Magnetfeld häufig nicht schnell genug reagiert werden. Dies ist insbesondere bei Magneten von Beschleunigeranlagen relevant, da hier schon kleine Abweichungen der Magnetfeldstärke vom Sollwert zu einer Ablenkung oder Defokussierung des Strahles führen und damit verbunden zu einem Auftreffen des Strahles auf Strahlrohrelemente. Letzteres hat wiederum zur Folge, dass Gamma- und Neutronenstrahlung erzeugt werden, sodass die Umgebung des Beschleunigers einer erhöhten Strahlenbelastung ausgesetzt wird. Außerdem kann es zu Beschädigungen von Strahlrohrelementen kommen. Um derartige Strahlenbelastungen und Beschädigungen zu vermeiden, ist es daher von besonderem Interesse, möglichst schnell auch kleine Veränderungen des Magnetfeldes feststellen zu können.

Dieses Problem der bekannten Magnetfeldmesseinrichtungen hängt damit zusammen, dass der bezüglich einer angemessenen Messzeit bestimmte Spitzenwert der Summe von Rauschen und Störsignalen im Ausgangssignal im Frequenzbereich von bis zu 10 kHz bei etwa 10⁻⁴ in Bezug auf den Vollausschlag liegt. Die Störsignale können dabei beispielsweise durch Schalten großer Lasten in der Umgebung, benachbarte Leistungselektronik oder Störspitzen im Versorgungsnetz zustande kommen. Beim Betrieb von Beschleunigeranlagen ist ein derartiger Spitzenwert jedoch zu hoch, da dort Grenzwerte gesetzt werden müssen, bei deren einmaligem Überschreiten der Beschleuniger abgeschaltet wird, die in der Größenordnung der obigen Spitzenwerte sind. Ansonsten ist nicht sichergestellt, dass es nicht zu einer Defokussierung bzw. unerlaubten Ablenkung kommt.

Daher liegt ausgehend vom Stand der Technik der vorliegenden Erfindung die Aufgabe zugrunde, eine Einrichtung sowie ein Verfahren zur Bestimmung der Stärke des Feldes eines Elektromagneten bereitzustellen, die die schnelle Bestimmung auch von kleinen Veränderungen des Magnetfeldes erlauben.

Diese Aufgabe wird durch eine Einrichtung gelöst mit einer Messeinrichtung zur Bestimmung des Magnetfeldes des Elektromagneten, einem Tiefpass-Element, das mit der ersten Zuleitung und der zweiten Zuleitung verbunden ist und das angepasst ist, aus der Spannung zwischen der ersten Zuleitung und der zweiten Zuleitung am Ausgang des Tiefpass-Elements ein Signal auszugeben, das an den zeitlichen Verlauf der Magnetfeldstärke in dem Elektromagneten angenähert ist, mit einem der Messeinrichtung nachgeschalteten Tiefpassfilter, mit einem zu dem Tiefpass-Element in Reihe geschalteten Hochpassfilter und mit einem Signalausgang, wobei der Ausgang der Messeinrichtung und der Ausgang des Tiefpass-Elements mit dem Signalausgang verbunden sind.

Im Folgenden wird unter der "Magnetfeldstärke" eines Elektromagneten die Stärke des Magnetfeldes im genutzten Bereich verstanden, also beispielsweise in dem Luftspalt zwischen den Polschuhen.

Erfindungsgemäß weist die Einrichtung zwei Zweige auf, die beide zu dem Signalausgang führen. Der erste Zweig umfasst die Messeinrichtung zur Bestimmung des Magnetfelds, die ein erstes Signal ausgibt, dessen Höhe ein Maß für die Magnetfeldstärke ist. Der zweite Zweig der Einrichtung umfasst ein Tiefpass-Element, das die an dem Magneten abfallende Spannung erfasst. Der zeitliche Verlauf des abgegriffenen Spannungssignals wird von dem Tiefpass-Element so verändert, dass er dem der Magnetfeldstärke in dem Magneten annähernd entspricht. Das Tiefpass-Element dient demnach dazu, den zeitlichen Verlauf der Magnetfeldstärke ausgehend von dem Spannungssignal zu "simulieren". Der Simulation liegt zugrunde, dass die in einer Spule induzierte Spannung der zeitlichen Ableitung des Magnetfeldes entspricht.

Erfindungsgemäß wird weiter ausgenutzt, dass die Abhängigkeit der Magnetfeldstärke eines Magneten von der angelegten Spannung durch einen Tiefpass erster Ordnung angenähert werden kann und das Spannungssignal am Ausgang des Tiefpass-Elements einen an den zeitlichen Verlauf des Feldes in einem Elektromagneten angenäherten Verlauf aufweist.

Ferner ist der Messeinrichtung ein Tiefpassfilter nachgeschaltet, sodass hochfrequente Anteile aus dem ausgegebenen Spannungssignal herausgefiltert werden und nicht zu dem Signalausgang in das Ausgangssignal gelangen. In dem zweiten Zweig ist ein dem Tiefpass-Element nachgeschaltetes Hochpassfilter vorgesehen, das dazu dient, nur die hochfrequenten Anteile, die mit "schnellen" Änderungen wie Sprüngen verbunden sind, zu dem Signalausgang hindurch zu lassen. Das Tiefpassfilter ist auf das im zweiten Zweig vorgesehene Hochpassfilter so abgestimmt, dass Anteile mit einer Frequenz, die das Hochpassfilter passieren können, nicht mehr das Tiefpassfilter im ersten Zweig passieren könnten. Insbesondere sind die Filterkurven so aufeinander abgestimmt, dass diese komplementär zueinander sind. Dies bedeutet, dass die Summe der beiden Filter-Übertragungsfunktionen über den gesamten betrachteten Frequenzbereich konstant ist. Dies lässt sich besonders einfach dadurch erreichen, dass ein Tiefpassfilter erster Ordnung und ein Hochpassfilter erster Ordnung verwendet werden, wobei beide die gleiche Eckfrequenz aufweisen. Zusätzlich müssen die beiden Zweige durch passende frequenzunabhängige Verstärkungsfaktoren aufeinander abgestimmt sein.

Durch das Tiefpassfilter und das Hochpassfilter wird erreicht, dass die niederfrequenten Anteile des am Signalausgang auftretenden Ausgangssignals aus dem ersten Zweig stammen. Dagegen gelangen die hochfrequenten Anteile des Ausgangssignals, das am Signalausgang ausgegeben wird, durch den zweiten Zweig. Somit ist im Ausgangssignal das gesamte Frequenz-Spektrum des Magnetfelds enthalten - im niederfrequenten Bereich mit der guten Stabilität bzw. Genauigkeit des ersten Zweiges und im höherfrequenten Bereich mit dem reduzierten Rauschen des ersten Zweiges.

Der Spitzenwert des Rauschens des Ausgangssignals am Signalausgang liegt bei einer erfindungsgemäßen Einrichtung im Bereich von 10⁻⁵ bis 10⁻⁶ in Bezug auf den Vollausschlag und ist damit im Vergleich zum Stand der Technik um wenigstens eine Größenordnung reduziert. Im Vergleich zu einer Einrichtung, .die lediglich die direkte Bestimmung des Magnetfeldes umfasst, erlaubt dies, kleine Veränderungen der Magnetfeldstärke schneller zu bestimmen. Somit können beispielsweise Magneten von Beschleunigeranlagen frühzeitig nachgeregelt werden oder der Strahl kann gestoppt werden, bevor es zu einer vollständigen Defokussierung und/oder unerlaubt großen Ablenkungen und damit verbunden zum unkontrollierten Auftreffen des Strahls auf Strahlrohrelemente kommt.

In einer bevorzugten Ausführungsform umfasst das Funktionsschema des Tiefpass-Elements einen Tiefpass-Element-Addierer mit einem ersten Eingang, einem zweiten Eingang und einem Ausgang, einen Tiefpass-Element-Integrator, der mit dem Ausgang des Tiefpass-Element-Addierers verbunden ist, und eine Rückführverbindung, wobei der erste Eingang des Tiefpass-Element-Addierers den Eingang des Tiefpass-Elements bildet, wobei der Ausgang des Tiefpass-Element-Integrators den Ausgang des Tiefpass-Elements bildet und wobei die Rückführverbindung den Ausgang des Tiefpass-Element-Integrators mit dem zweiten Eingang des Tiefpass-Element-Addierers verbindet. Hierbei wird zum einen ausgenutzt, dass sich das Strom-Spannungsverhalten eines Magneten auch durch die Kombination eines Integrators mit einer negativen Rückkopplung simulieren lässt, wobei das Ausgangssignal des Integrators an dem Tiefpass-Element-Addierer vom Eingangssignal abgezogen wird. Zur Anpassung dieses Ausführungsbeispiels eines Tiefpass-Elements an einen vorgegebenen Elektromagneten muss lediglich die Zeitkonstante des Integrators, die den Anstieg des Ausgangssignals als Funktion der Zeit festlegt, entsprechend gewählt werden. Ein derartiger Aufbau stellt einen Tiefpassfilter erster Ordnung dar.

Diese bevorzugte Ausführungsform kann in der Weise realisiert werden, dass das Tiefpass-Element als Tiefpass aus ohmschem Widerstand und Kondensator ausgebildet ist, wobei die Grenzfrequenz ω_{G} des Tiefpasses an die Induktivität L und den ohmschen Widerstand R des Magneten angepasst sind.

Alternativ lässt sich die obige bevorzugte Ausführungsform auch realisieren, indem das Tiefpass-Element einen ersten Widerstand, einen Operationsverstärker, einen Kondensator und einen zweiten Widerstand aufweist, wobei der erste Widerstand mit dem invertierenden Eingang des Operationsverstärkers verbunden ist, wobei der Kondensator zu dem invertierenden Eingang und dem Ausgang des Operationsverstärkers parallel geschaltet ist und wobei der zweite Widerstand zu dem Kondensator sowie zu dem invertierenden Eingang und dem Ausgang des Operationsverstärkers parallel geschaltet ist. Eine derartige Schaltung stellt ebenfalls einen Tiefpass erster Ordnung dar.

In weiter bevorzugter Weise ist eine Temperaturberechnungsschaltung vorgesehen, um Temperaturveränderungen in dem Magneten zu berücksichtigen. Dies ermöglicht, dass das von dem Tiefpass-Element auf Basis der erfassten Magnetspannung bestimmte Magnetfeldstärke-Signal entsprechend der wärmebedingten Widerstandsänderung des Magneten korrigiert werden kann. Insbesondere wird dadurch erreicht, dass eine Erhöhung der Magnetspannung, die lediglich auf eine Widerstandsänderung zurückgeht, nicht zu einer Veränderung der am Signalausgang ausgegebenen Magnetfeldstärke führt.

Die Temperaturberechnungsschaltung, die dem Tiefpass-Element nachgeschaltet ist, kann in bevorzugter Weise realisiert werden, indem sie einen Quadrierer, einen Rückkopplungs-Addierer, der über seinen ersten Eingang mit dem Ausgang des Quadrierers verbunden ist, einen Integrator, dessen Eingang mit dem Ausgang des Rückkopplungs-Addierers verbunden ist, eine Rückführleitung, die den Ausgang des Integrators mit dem zweiten Eingang des Rückkopplungs-Addierers verbindet, einen Widerstandswert-Addierer, der einen ersten Eingang, einen zweiten Eingang, der mit dem Ausgang des Integrators verbunden ist, und einen Ausgang aufweist, und eine Widerstandswertquelle, die ein Spannungssignal an den zweiten Eingang des Widerstandswert-Addierers liefert, umfasst, wobei in der Rückführverbindung des Tiefpass-Elements ein Multiplizierer vorgesehen ist und wobei der Ausgang des Widerstandswert-Addierers mit dem Multiplizierer verbunden ist.

Dabei ist es für die Funktionsweise der Temperaturberechnungsschaltung lediglich erforderlich, dass das Verhältnis des Ausgangssignals des Quadrierers zu dem Eingangssignal eine quadratische Beziehung aufweist. Dies bedeutet, dass für den Fall, wo lediglich Pulse einer festen Höhe an den Magneten angelegt werden, auch ein lineares Bauteil als "Quadrierer" verwendet werden kann.

Durch den Integrator, in den das durch den Quadrierer quadrierte Stromstärke-Signal des Tiefpass-Elements eingespeist wird, wird die Zunahme des ohmschen Widerstandes in Folge der Erwärmung des Magneten simuliert, wobei angenommen wird, dass die Erwärmung proportional zur aufgenommenen Leistung ist und damit proportional zum Quadrat des Stromes. Um schließlich ein Signal zu erhalten, das proportional zum Gesamtwiderstand des Magneten ist, wird durch die Widerstandswertquelle an dem Widerstandswert-Addierer ein zusätzliches Signal zu dem Ausgangssignal des Integrators addiert, das dem Widerstand des Magneten bei Umgebungstemperatur entspricht.

Eine Kühlung des Magneten, beispielsweise durch Konvektion, wird außerdem dadurch berücksichtigt, dass die Temperaturberechnungsschaltung einen Rückkopplungs-Addierer, der über seinen ersten Eingang mit dem Ausgang des Quadrierers und über seinen Ausgang mit dem Eingang des Integrators verbunden ist, und eine Rückführleitung aufweist, wobei die Rückführleitung den Ausgang des Integrators mit dem zweiten Eingang des Rückkopplungs-Addierers verbindet. Durch eine negative Rückkopplung über die Rückführleitung wird dabei berücksichtigt, dass der Temperaturanstieg mit steigender Temperatur aufgrund der Kühlung immer geringer ausfällt, da die Wärmeabgabe proportional zur Temperaturdifferenz zwischen Magnet und Umgebung ist.

Das Ausgangssignal der Temperaturberechnungsschaltung, das ein Maß für den Gesamtwiderstand des Magneten ist, wird mit dem Ausgangssignal des Tiefpass-Element-Integrators, also dem angenäherten Magnetstrom multipliziert, um so ein Maß für den Spannungsabfall aufgrund des ohmschen Widerstandes zu erhalten, der dann an dem Tiefpass-Element-Addierer von der Gesamtmagnetspannung abgezogen wird. Somit wird dem Integrator nach dieser Subtraktion nur der Teil der Magnetspannung zugeführt, der auf die Induktivität bzw. Magnetfeldänderung zurückgeht. Der Ausgang des Tiefpass-Elements wird damit unabhängig von der strombedingten Erwärmung.

Weiterhin ist es bevorzugt, wenn dem Tiefpass-Element ein Umwandler nachgeschaltet ist, der angepasst ist, das vom Tiefpass-Element ausgegebene zweite Signal, das die Magnetfeldstärke bzw. den Magnetstrom annähert, in ein Magnetfeldstärkesignal mit verbesserter Genauigkeit umzuwandeln. Durch den Umwandler wird ermöglicht, Sättigungseffekte in dem Magneten zu berücksichtigen, bei denen eine Erhöhung des Stromes nur noch eine geringe Erhöhung des Magnetfeldes bewirkt. Diese Berücksichtigung von Sättigungseffekten kann dadurch erreicht werden, dass in dem Umwandler eine Tabelle hinterlegt ist, die die Magnetfeldstärke-Signale zu simulierten Stromstärke-Signalen aus dem Tiefpass-Element enthält. Weiterhin können durch den Umwandler Hysterese-Effekte bei der Umwandlung des Stromstärke-Signals in ein Magnetfeldstärke-Signal einbezogen werden.

Dabei ist es weiter bevorzugt, wenn der Umwandler einen Ableitungsausgang aufweist, der ein Signal liefert, das proportional zum Kehrwert der Ableitung der Magnetfeldstärke im Elektromagneten als Funktion des Stromes ist, wobei zwischen dem Tiefpass-Element-Addierer und dem Tiefpass-Element-Integrator ein Multiplizierer vorgesehen ist, dessen erster Eingang mit dem Tiefpass-Element-Addierer und dessen Ausgang mit dem Tiefpass-Element-Integrator verbunden ist, und wobei der Ableitungsausgang mit dem zweiten Eingang des Multiplizierers verbunden ist.

Dadurch ist es möglich, Sättigungseffekte auch hinsichtlich der Veränderung der Magnetfeldstärke als Funktion der Änderung der Magnetspannung zu berücksichtigen. Die in Folge der Sättigungseffekte eintretende Änderung der Induktivität wird dann schon beim eingehenden Magnetspannungssignal einbezogen.

Die in den vorstehend beschriebenen Ausführungsformen genannten Addierer, Multiplizierer, Integratoren, Tiefpassfilter, Hochpassfilter und Operationsverstärker sind herkömmliche elektrotechnische Bauteile oder Baugruppen, die zur Ausführung der Erfindung nicht besonders angepasst sein müssen und die dem Fachmann aus dem Stand der Technik bekannt sind. Es kann lediglich erforderlich sein, bestimmte Parameter wie Zeitkonstanten beispielsweise in Abhängigkeit der Parameter des Elektromagneten zu wählen.

In einer ersten Alternative kann die Messeinrichtung zur Bestimmung des Magnetfeldes direkt das Magnetfeld messen, sodass die Messeinrichtung als Magnetfeldstärke-Messeinrichtung ausgebildet ist. In diesem Fall kann die Messeinrichtung insbesondere als Hall-Sonde ausgebildet sein, die sich im Luftspalt des Magneten befindet. In einer zweiten Alternative ist die Messeinrichtung als Magnetstrommesseinrichtung ausgeführt, wobei es hier bevorzugt ist, einen DCCT einzusetzen oder einen Magnetfeldsensor, der das die Zuleitung umgebende Magnetfeld misst. In dieser zweiten Alternative wird also nicht das Magnetfeld im Magneten direkt gemessen, sondern die Magnetfeldstärke wird aus dem gemessenen Strom bestimmt.

Die obige Aufgabe wird außerdem durch ein Verfahren gelöst, bei dem ein erstes Signal erfasst wird, dessen Höhe ein direktes Maß für die Magnetfeldstärke des Elektromagneten ist, bei dem die über dem Elektromagneten abfallende Spannung erfasst wird, bei dem aus der erfassten Spannung ein zweites Signal erzeugt wird, wobei die erfasste Spannung Tiefpass-gefiltert wird, sodass der zeitliche Verlauf des zweiten Signals an den der Magnetfeldstärke in dem Elektromagneten angenähert wird, bei dem das erste Signal und das zweite Signal zu einem Ausgangssignal kombiniert werden und bei dem das erste Signal und das zweite Signal gefiltert werden, sodass nur niederfrequente Anteile des ersten Signals und nur hochfrequente Anteile des zweiten Signals in das Ausgangssignal eingehen.

Erfindungsgemäß werden zwei Signale erfasst, die anschließend zu einem Ausgangssignal kombiniert werden. Das erste Signal wird durch Erfassen der Stärke des Magnetfelds erzeugt, wobei dies direkt oder durch Erfassen des Magnetstromes erfolgen kann. Das zweite Signal wird aus der an dem Magneten abfallenden Spannung bestimmt, wobei das abgegriffene Spannungssignal Tiefpass-gefiltert wird, sodass sein zeitlicher Verlauf dem der Magnetfeldstärke in dem Magneten entspricht. Die Bestimmung dient demnach dazu, den zeitlichen Verlauf des Magnetstromes bzw. des Magnetfeldes ausgehend von dem Spannungssignal zu "simulieren", wobei das zweite Signal dann ein Maß für die Magnetfeldstärke ist, das im Vergleich zu dem ersten Signal ein reduziertes Rauschen aufweist. Damit kann eine Änderung des Magnetfeldes mit Hilfe des zweiten Signals schneller bestimmt werden, da insbesondere auch kleine Änderungen früher eine gegenüber dem Rauschen signifikante Abweichung darstellen.

Um zu erreichen, dass das zweite Signal im Wesentlichen nur dann in das Ausgangssignal eingeht, wenn schnelle Änderungen der Magnetfeldstärke auftreten, werden das erste Signal und das zweite Signal gefiltert, sodass nur niederfrequente Anteile des ersten Signals und nur hochfrequente Anteile des zweiten Signals in das Ausgangssignal eingehen.

Zur Erzeugung des zweiten Signals ist es bevorzugt, wenn das Signal der erfassten Spannung über die Zeit integriert wird und das integrierte Signal dann das zweite Signal bildet, wobei das zweite Signal von der erfassten Spannung vor der Integration abgezogen wird. Eine derartige Verarbeitung des Signals der erfassten Spannung mit einer negativen Rückkopplung ermöglicht, den zeitlichen Verlauf der Magnetfeldstärke im Elektromagneten auf der Grundlage der erfassten Magnetspannung in einfacher Weise zu simulieren. In weiter bevorzugter Weise kann die beschriebene Funktionsweise durch einen Tiefpassfilter realisiert werden.

Weiterhin ist es bevorzugt, wenn bei der Erzeugung des zweiten Signals die Temperaturerhöhung des Elektromagneten berücksichtigt wird, um so die Genauigkeit der Simulation weiter zu erhöhen. Schließlich kann in weiter bevorzugter Weise eine Umwandlung des zweiten Signals erfolgen, sodass das zweite Signal in ein Signal proportional zur Magnetfeldstärke umgewandelt wird, das eine verbesserte Genauigkeit aufweist. Hierbei können auch Sättigungs- und Hysterese-Effekte in dem Magneten mit in die Simulation einfließen.

Im Folgenden wird die vorliegende Erfindung anhand einer lediglich bevorzugte Ausführungsbeispiele zeigenden Zeichnung erläutert. In der Zeichnung zeigen
Fig. 1 ein Funktionsschema eines ersten Ausführungsbeispiels einer erfindungsgemäßen Einrichtung zur Bestimmung der Stärke des Magnetfeldes eines Elektromagneten,
Fig. 2 ein erstes Schaltschema gemäß dem ersten Ausführungsbeispiel,
Fig. 3 ein zweites Schaltschema gemäß dem ersten Ausführungsbeispiel,
Fig. 4 ein drittes Schaltschema gemäß dem ersten Ausführungsbeispiel,
Fig. 5 ein Funktionsschema eines zweiten Ausführungsbeispiels mit einer Temperaturberechnungsschaltung und
Fig. 6 ein Funktionsschema eines dritten Ausführungsbeispiels mit einer Temperaturberechnungsschaltung.

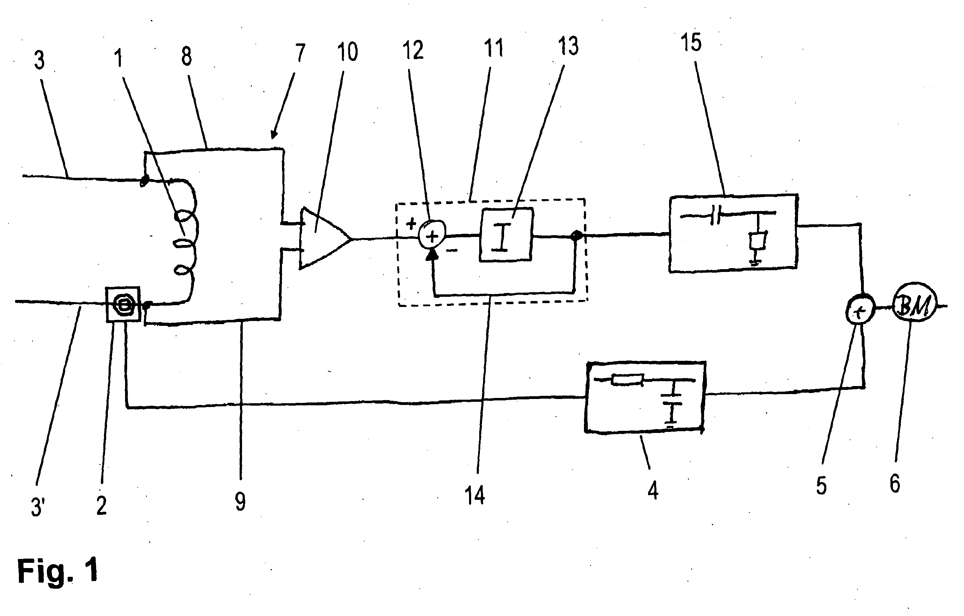

In Fig. 1 ist das Funktionsschema eines ersten Ausführungsbeispiels einer erfindungsgemäßen Einrichtung zur Bestimmung der Magnetfeldstärke eines Elektromagneten 1, der nur schematisch dargestellt ist, wiedergegeben. Das Funktionsschema der Einrichtung weist einen ersten Zweig auf, in dem eine Messeinrichtung zur Bestimmung des Magnetfeldes vorgesehen ist, wobei es sich in diesem insoweit bevorzugten Ausführungsbeispiel um eine Magnetstrom-Messeinrichtung handelt, die als DCCT (Direct Current Current Transformer) 2 ausgebildet ist. Alternativ kann auch ein Magnetfeldsensor verwendet werden, der um die Zuleitungen 3, 3' angeordnet ist. Die Spulen des DCCT 2 umgeben eine der Zuleitungen 3, 3' des Elektromagneten 1. Der Ausgang des DCCT 2 ist mit einem in dem ersten Zweig vorgesehenen Tiefpassfilter 4 verbunden. Der Ausgang des Tiefpassfilters 4 ist mit einem Addierer 5 verbunden, dessen Ausgang zu einem Signalausgang 6 führt, an dem ein Ausgangssignal ausgegeben wird.

Wie das Funktionsschema gemäß Fig. 1 weiter zeigt, weist die Einrichtung einen zweiten Zweig auf, der einen Spannungseingang 7 umfasst mit zwei Anschlüssen 8, 9, die mit dem Eingang eines Differenzverstärkers 10 verbunden sind. Die Anschlüsse 8, 9 sind mit den Zuleitungen 3, 3' des Elektromagneten 1 verbunden, sodass sie die über dem Elektromagneten 1 abfallende Spannung erfassen. Der Ausgang des Differenzverstärkers 10 ist mit dem Eingang eines Tiefpass-Elements 11 verbunden, das einen Tiefpass-Element-Addierer 12 mit einem ersten Eingang, einem zweiten Eingang und einem Ausgang umfasst. Des Weiteren ist ein Tiefpass-Element-Integrator 13 vorgesehen, der mit dem Ausgang des Tiefpass-Element-Addierers 12 verbunden ist. Der erste Eingang des Tiefpass-Element-Addierers 12 bildet dabei den Eingang des Tiefpass-Elements 11 und der Ausgang des Tiefpass-Element-Integrators 13 den Ausgang des Tiefpass-Elements 11. Außerdem ist eine Rückführverbindung 14 vorgesehen, die den Ausgang des Tiefpass-Element-Integrators 13 mit dem zweiten Eingang des Tiefpass-Element-Addierers 12 verbindet, wobei das über die Rückführverbindung 14 zugeführte Ausgangssignal des Tiefpass-Element-Integrators 13 in dem Tiefpass-Element-Addierer 12 von dem Magnetspannungssignal abgezogen wird, wie durch das Minus-Zeichen angedeutet ist. Dadurch wird über die Rückführverbindung 14 eine negative Rückkopplung realisiert. Um das Tiefpass-Element 11 schließlich an den Elektromagneten 1 anzupassen, wird die Zeitkonstante des Tiefpass-Element-Integrators 13 entsprechend gewählt. Eine solche Anordnung aus Addierer 12, Integrator 13 und Rückführverbindung 14 bildet ein Tiefpassfilter erster Ordnung.

Dem Tiefpass-Element 11 ist ein Hochpassfilter 15 nachgeschaltet, dessen Ausgang wiederum mit dem Addierer 5 verbunden ist. Das Hochpassfilter 15 dient dazu, nur den hochfrequenten Anteil des zweiten Signals aus dem Tiefpass-Element 11 zu dem Addierer 5 zu lassen und ist auf das Tiefpassfilter 4 des ersten Zweiges abgestimmt.

Dabei ist das Tiefpassfilter 4 insbesondere so auf das Hochpassfilter 15 abgestimmt, dass Anteile mit einer Frequenz, die das Hochpassfilter 15 passieren können, nicht mehr das Tiefpassfilter 4 passieren könnten. Die Filterkurven sind komplementär zueinander, was bedeutet, dass die Summe der beiden Filter-Übertragungsfunktionen über den gesamten betrachteten Frequenzbereich konstant ist. Dies lässt sich besonders einfach dadurch erreichen, dass ein Tiefpassfilter 1.Ordnung und ein Hochpassfilter 1.Ordnung verwendet wird, wobei beide die gleiche Eckfrequenz aufweisen. Zusätzlich müssen die beiden Zweige durch passende frequenzunabhängige Verstärkungsfaktoren aufeinander abgestimmt sein.

Das erste Ausführungsbeispiel der erfindungsgemäßen Einrichtung, dessen Funktionsschema in Fig. 1 dargestellt ist, arbeitet wie folgt. Zum einen wird im ersten Zweig der durch den Elektromagneten 1 fließende Strom mittels des DCCT 2 gemessen, sodass ein erstes Signal erfasst wird, dessen Höhe ein direktes Maß für die Magnetfeldstärke des Elektromagneten 1 ist. Die niederfrequenten Anteile des Signals des DCCT 2 können das Tiefpassfilter 4 passieren und gelangen so zu dem Addierer 5 und über diesen zu dem Signalausgang 6. Die optimale Grenzfrequenz des Tiefpassfilters 4 bzw. die Übergangs frequenz hängen von den Betriebsbedingungen des Elektromagneten 1 und den Kennwerten der Messeinrichtung ab. Die Grenzfrequenz kann dabei etwa zwischen 5 Hz und 5 kHz liegen.

Parallel dazu wird in dem zweiten Zweig über die Anschlüsse 8, 9 die an dem Elektromagneten 1 anliegende Spannung erfasst, und es wird mittels des Differenzverstärkers 10 ein Spannungssignal erzeugt, das proportional zu dieser Spannung ist. Dieses Spannungssignal wird dem Tiefpass-Element 11 zugeleitet, das das Magnetspannungssignal derart verändert, dass das ausgegebene zweite Signal annähernd den zeitlichen Verlauf hat, den auch die Magnetfeldstärke in dem Elektromagneten 1 hat. Dies geschieht in der Weise, dass das Spannungssignal aus dem Differenzverstärker in dem Tiefpass-Element-Integrator 13 über die Zeit integriert wird, sodass an dessen Ausgang das integrierte Spannungssignal ausgegeben wird. Dieses integrierte Signal wird in dem Tiefpass-Element-Addierer 12 von dem Spannungssignal des Differenzverstärkers 10 abgezogen, sodass eine negative Rückkopplung realisiert wird.

Die hochfrequenten Anteile des Signals des Tiefpass-Elements 11 oberhalb der obigen Grenzfrequenz gelangen über das Hochpassfilter 15 zum Addierer 5, wo sie mit dem niederfrequenten Signal des ersten Zweiges zu einem Ausgangssignal kombiniert werden. Somit gelangen über den zweiten Zweig Signale zu dem Signalausgang 6, denen schnelle Änderungen der Magnetfeldstärke zugrunde liegen, während solche in dem ersten Zweig durch das Tiefpassfilter 4 blockiert werden.

Durch die in dem zweiten Zweig vorgesehene "Simulation" des Magnetromes bzw. des Magnetfeldes in dem Elektromagneten 1 ist es möglich, im ersten Zweig ein Tiefpassfilter 4 vorzusehen und damit das durch den DCCT 2 erzeugte Rauschen und die erzeugten Störsignale am Signalausgang 6 zu reduzieren, sodass durch die erfindungsgemäße Einrichtung auch kleine Veränderungen des Magnetstroms und damit auch Veränderungen des durch den Elektromagneten 1 erzeugten Feldes schnell festgestellt werden können.

Dies ist insbesondere bei an Beschleunigeranlagen verwendeten Elektromagneten relevant. Um das Feld der Magneten stabil zu halten, ist eine möglichst genaue Messung des Feldes mit einem geringen Rauschen erforderlich. Außerdem soll eine Veränderung des Magnetfeldes möglichst schnell detektiert werden, um zu verhindern, dass der Strahl defokussiert oder unerlaubt stark abgelenkt wird und möglicherweise Schäden anrichtet.

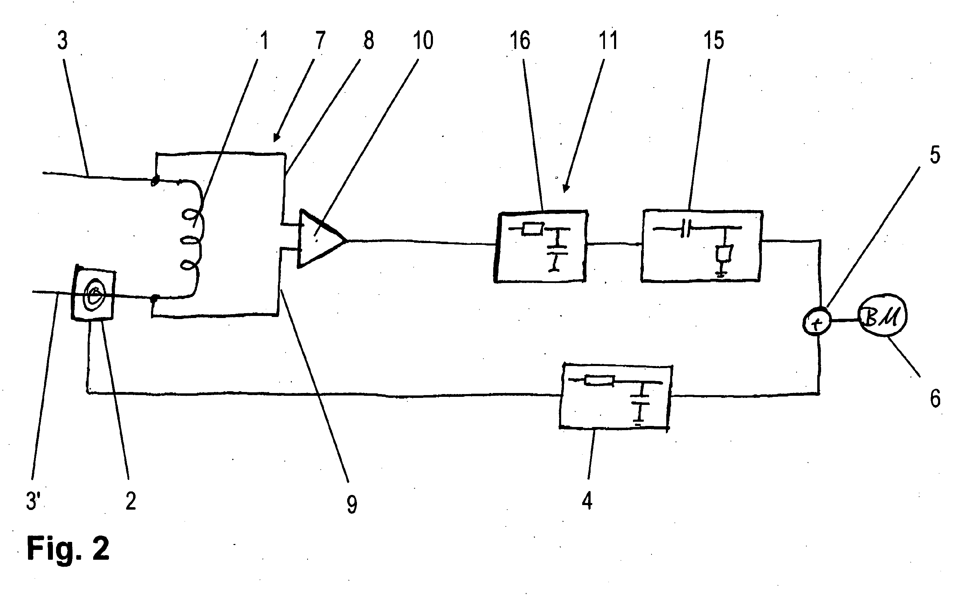

Das in Fig. 1 wiedergegebene Funktionsschema kann in einer ersten Alternative durch das in Fig. 2 dargestellte Schaltschema realisiert werden. Hierbei ist das Tiefpass-Element 11 als Tiefpass 16 mit einem Widerstand und einem Kondensator ausgebildet. Dabei ist die Grenzfrequenz ω_{G} des Tiefpasses 16 derart gewählt, dass das von dem Tiefpass 16 ausgegebene Spannungssignal dem zeitlichen Verlauf der Magnetfeldstärke in dem Magneten 1 entspricht, die sich aus der durch die Anschlüsse 8, 9 erfassten Magnetspannung ergibt. Die Grenzfrequenz ω_{G} des Tiefpasses 16 ist damit insbesondere auf die Induktivität L und den ohmschen Widerstand R des Elektromagneten 1 abgestimmt.

Dabei wird ausgenutzt, dass das Übertragungsverhalten eines Tiefpasses erster Ordnung annähernd den gleichen Verlauf hat, wie die Beziehung zwischen Strom und Spannung bei einem ohmschen Widerstand und einer dazu in Reihe geschalteten Induktivität, sodass ein Tiefpass erster Ordnung ein "Modell" für einen Elektromagneten darstellt.

Es ist damit möglich, den zeitlichen Verlauf der Magnetfeldstärke in dem Elektromagneten 1 als Funktion der erfassten Spannung durch den Tiefpass 16 des Tiefpass-Elements 11 zu simulieren, sodass das Ausgangsignal des Tiefpass-Elements 11 den zeitlichen Verlauf des Stromes in dem Elektromagneten 1 annähert. Der Strom wiederum ist annähernd ein Maß für die Stärke des Magnetfeldes in dem Elektromagneten 1.

Die Kombination aus dem Tiefpass-gefilterten Signal des DCCT 2 und dem Hochpass-gefilterten Signal des Tiefpasses 16 nutzt zum einen die hohe Genauigkeit bzw. Stabilität des DCCT 2 im Niederfrequenzbereich und das geringe Rauschen des Tiefpass-gefilterten Spannungssignals im höherfrequenten Bereich andererseits aus.

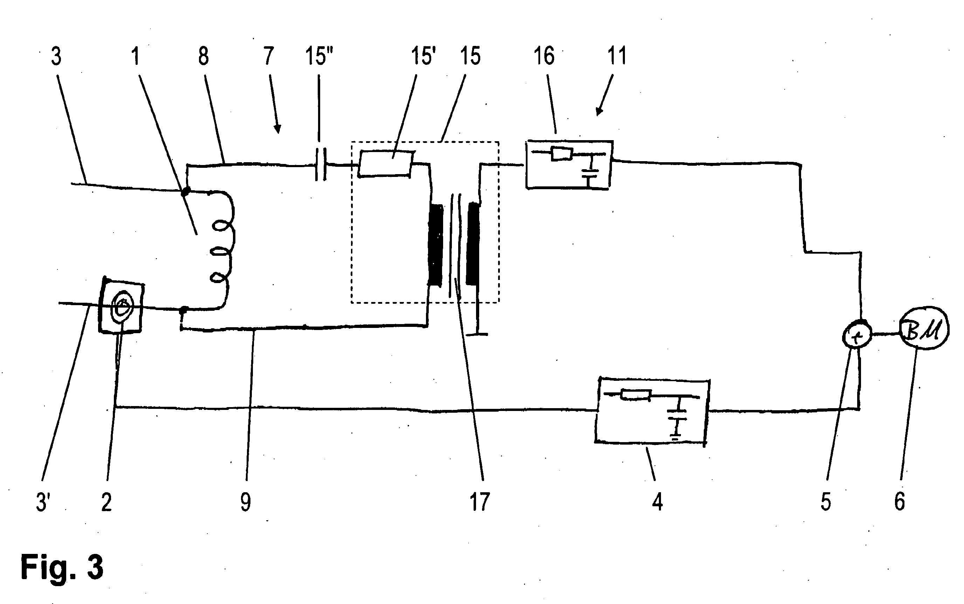

In Fig. 3 ist ein zweites alternatives Schaltschema dargestellt. Hier sind im Unterschied zum vorhergehenden Schaltschema das Hochpassfilter 15 dem Tiefpass-Element 11 zur Simulation des zeitlichen Verlaufs der Magnetfeldstärke vorgeschaltet. Das Hochpassfilter 15 wird im konkreten Aufbau durch den Widerstand 15' im Spannungseingang 7 und die Induktivität eines Transformators 17 gebildet. Vorteilhaft an dieser Ausführungsform ist die durch den Transformator 17 bewirkte galvanische Trennung und gleichzeitig Bildung der Differenzspannung der Zuleitungen 3, 3'. Da der Transformator 17 von sich aus Hochpass-Verhalten aufweist, ist hier die dargestellte Reihenfolge aus Tiefpass-Element 11, das hier durch den Tiefpass 16 gebildet wird, und dem Hochpassfilter 15 erforderlich. Falls die Eingangsimpedanz des Tiefpass-Elements 11 zu niedrig ist, muss ein Verstärker mit hochohmigem Eingang vorgeschaltet werden. Der Kondensator 15" im Spannungseingang 7 verhindert eine Gleichstrom-Ansteuerung des Transformators 17 und damit Verzerrungen durch Sättigung des Transformators 17 sowie unnötige Erwärmung von Widerstand 15' und Transformator 17. Seine Kapazität muss ausreichend groß gewählt werden, um die Übertragungsfunktion des durch Widerstand 15' und Transformator 17 gebildeteten Hochpassfilters 15 nicht zu stark zu verfälschen.

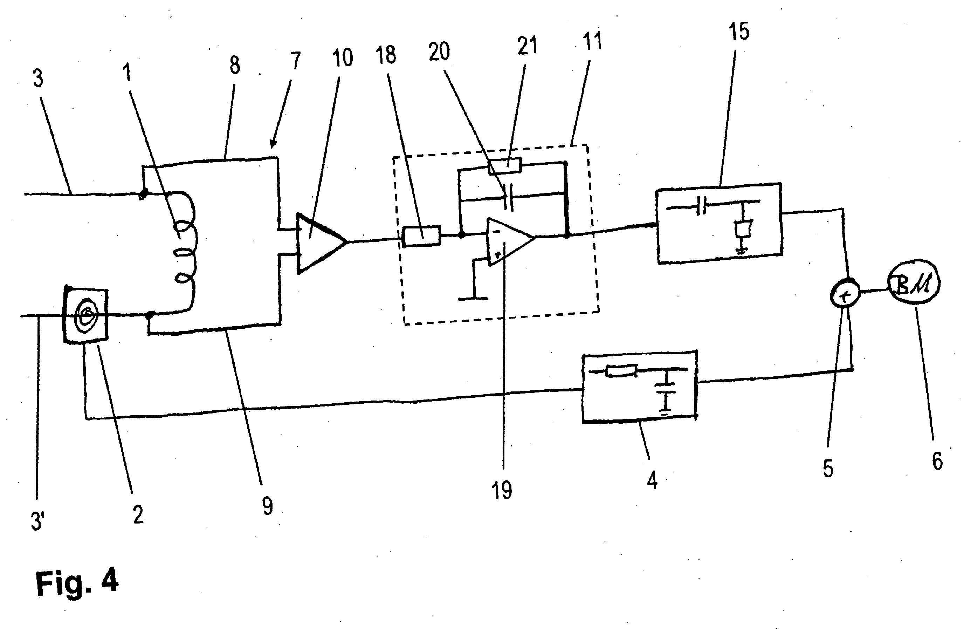

Ein Schaltschema einer weiteren Alternative zur Realisierung des ersten Ausführungsbeispiels ist in Fig. 4 dargestellt. Es enthält als Messeinrichtung in dem ersten Zweig wieder einen DCCT 2, der über den Tiefpassfilter 4 mit dem Addierer 5 und dem Signalausgang 6 verbunden ist. Bei diesem Schaltschema umfasst das Tiefpass-Element 11 einen ersten Widerstand 18, einen Operationsverstärker 19, einen Kondensator 20 und einen zweiten Widerstand 21. Der erste Widerstand 18 ist mit dem invertierenden Eingang des Operationsverstärkers 19 verbunden und der Kondensator 20 ist zu dem invertierenden Eingang und dem Ausgang des Operationsverstärkers 19 parallel geschaltet. Außerdem ist der zweite Widerstand 21 zu dem Kondensator 20 sowie zu dem invertierenden Eingang und dem Ausgang des Operationsverstärkers 19 parallel geschaltet. Durch einen derartigen Aufbau des Tiefpass-Elements 11 lässt sich ebenfalls das Strom-Spannungsverhalten an einem Magneten simulieren, da dies ebenfalls einen Tiefpass erster Ordnung darstellt.

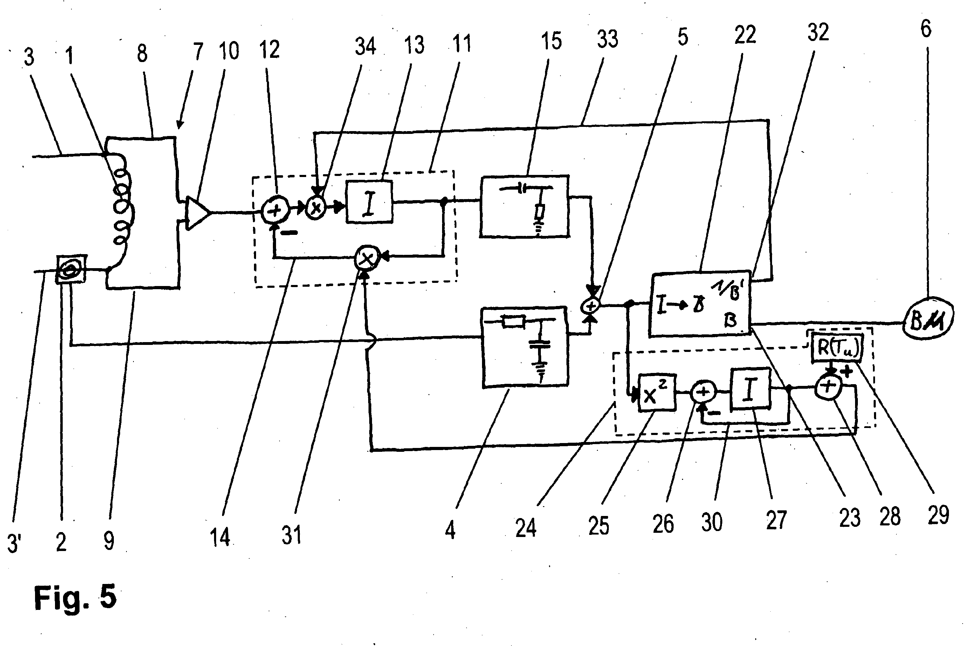

In Fig. 5 ist das Funktionsschema eines zweiten Ausführungsbeispiels einer Einrichtung gemäß der vorliegenden Erfindung dargestellt.

In diesem Fall weist der erste Zweig, wie bei dem ersten Ausführungsbeispiel auch, als Messeinrichtung zur Bestimmung des Magnetfeldes des Elektromagneten 1 einen DCCT 2 auf. Das Signal des DCCT 2 wird wieder über ein Tiefpassfilter 4 zu einem Addierer 5 geleitet, dem jedoch in diesem Ausführungsbeispiel eine Temperaturberechnungsschaltung 24 nachgeschaltet ist, durch die Veränderungen des ohmschen Widerstands des Elektromagneten 1 infolge einer stromflussbedingten Temperaturerhöhung berücksichtigt werden. Des Weiteren ist dem Addierer 5 ein Umwandler 22 nachgeschaltet, der im Folgenden näher beschrieben wird und der einen Ausgang 23 aufweist, über den ein Ausgangssignal an den Signalausgang 6 ausgegeben wird.

Wie in dem ersten Ausführungsbeispiel auch, weist der zweite Zweig nach dem Spannungseingang 7 und dem Differenzverstärker 10 ein Tiefpass-Element 11 auf, das einen Tiefpass-Element-Addierer 12, einen Tiefpass-Element-Integrator 13 und eine Rückführverbindung 14 umfasst, wobei diese in der bereits beschriebenen Weise arbeiten. Dem Tiefpass-Element 11 ist wiederum ein Hochpassfilter 15 nachgeschaltet, dessen Ausgangssignal zu dem Addierer 5 geleitet wird. Das Ausgangssignal des Addierers 5 wird einerseits zu dem Umwandler 22 geleitet und andererseits zu der Temperaturberechnungsschaltung 24.

Die Temperaturberechnungsschaltung 24 ist über das Hochpassfilter 15 und den Addierer 5 dem Tiefpass-Element-Integrator 13 nachgeschaltet und erhält als Eingangssignal die durch den Addierer 5 gebildete Summe. Sie erhält damit auch das Signal aus dem ersten Zweig und weist einen Quadrierer 25, einen Rückkopplungs-Addierer 26, einen Integrator 27 und einen Widerstandswert-Addierer 28 auf. Der Rückkopplungs-Addierer 26 ist über seinen ersten Eingang mit dem Ausgang des Quadrierers 25 und über seinen Ausgang mit dem Eingang des Integrators 27 verbunden. Dem Integrator 27 ist ein Widerstandswert-Addierer 28 nachgeschaltet, der einen ersten Eingang, einen zweiten Eingang, der mit dem Ausgang des Integrators 27 verbunden ist, und einen Ausgang aufweist. Des Weiteren ist eine Widerstandswertquelle 29 vorgesehen, die ein Spannungssignal an den zweiten Eingang des Widerstandswert-Addierers 28 liefert. Außerdem verbindet eine Rückführleitung 30 den Ausgang des Integrators 27 mit dem zweiten Eingang des Rückkopplungs-Addierers 26.

Um das Ausgangssignal der Temperaturberechnungsschaltung 24 bei der Simulation der Magnetfeldstärke zu berücksichtigen, ist in der Rückführverbindung 14 des Tiefpass-Elements 11 ein Multiplizierer 31 vorgesehen, der mit dem Ausgang des Widerstandswert-Addierers 28 der Temperaturberechnungsschaltung 24 verbunden ist.

Die Funktionsweise der Temperaturberechnungsschaltung 24 ist die Folgende. Durch den Integrator 27, in den das durch den Quadrierer 25 quadrierte Magnetfeldstärke-Signal des Tiefpass-Elements 11 eingespeist wird, wird die Erwärmung des Elektromagneten 1 simuliert. Dabei wird zugrunde gelegt, dass die Erwärmung proportional zur Leistung ist und damit proportional zum Quadrat des Stromes. Des Weiteren wird angenommen, dass die Zunahme des ohmschen Widerstandes in Folge der Erwärmung proportional zur Temperaturzunahme ist. Um am Ausgang der Temperaturberechnungsschaltung 24 schließlich ein Signal zu erhalten, das proportional zum Gesamtwiderstand des Elektromagneten 1 ist, wird durch die Widerstandswertquelle 29 an dem Widerstandswert-Addierer 28 ein zusätzliches Signal zu dem Ausgangssignal des Integrators 27 addiert, das dem Widerstand des Elektromagneten 1 bei Umgebungstemperatur entspricht. Das Ausgangssignal der Temperaturberechnungsschaltung 24, das damit ein Maß für den Gesamtwiderstand des Elektromagneten 1 ist, wird mit dem Ausgang des Tiefpass-Element-Integrators 13, also dem Magnetstrom-Signal multipliziert (Multiplizierer 31), um so ein Maß für den Spannungsabfall aufgrund des ohmschen Widerstandes zu erhalten, der dann an dem Tiefpass-Element-Addierer 12 von dem Signal der Gesamtmagnetspannung abgezogen wird. Somit wird dem Tiefpass-Element-Integrator 13 nach dieser Subtraktion nur der Teil der Magnetspannung zugeführt, der auf die Induktivität des Magneten zurückgeht. Der Ausgang des Tiefpass-Elements 11 wird damit temperaturunabhängig hinsichtlich des ohmschen Widerstandes des Elektromagneten.

Um eine Kühlung des Elektromagneten 1, beispielsweise durch Konvektion, zu berücksichtigen, ist die negative Rückkopplung über die Rückführleitung 30 und den Rückkopplungs-Addierer 26 vorgesehen. Durch die negative Rückkopplung wird berücksichtigt, dass der Temperaturanstieg mit steigender Temperatur aufgrund der Kühlung immer geringer ausfällt, da die Wärmeabgabe proportional zur Temperaturdifferenz zwischen Magnet 1 und Umgebung ist.

Bei dem Ausführungsbeispiel gemäß Fig. 5 ist ferner ein dem Addierer 5 nachgeschalteter Umwandler 22 vorgesehen, der das eingehende Magnetstromsignal aus den beiden Zweigen in ein Spannungssignal umwandelt, das proportional zur Magnetfeldstärke des Elektromagneten 1 ist, wobei dieses Ausgangssignal an dem Ausgang 23 ausgegeben und zu dem Signalausgang 6 geleitet wird. Dabei ist in diesem bevorzugten Ausführungsbeispiel in dem Umwandler 22 eine Tabelle hinterlegt, die jedem Wert des Magnetstromsignals einen entsprechenden Magnetfeldstärke-Wert zuweist. Auf diese Weise werden in diesem Ausführungsbeispiel einer erfindungsgemäßen Einrichtung Sättigungseffekte in dem Elektromagneten 1 berücksichtigt, in deren Folge ein Anstieg des Magnetstromes zu einer mit wachsendem Magnetstrom immer geringer werdenden Erhöhung der Magnetfeldstärke führt.

Der Umwandler 22 weist außerdem einen Ausgang 32 auf, an dem ein Spannungssignal ausgegeben wird, das proportional zum Kehrwert der Ableitung der Magnetfeldstärke als Funktion des Magnetstromes ist. Dieses wird über die Verbindung 33 einem Multiplizierer 34 zugeleitet, der zwischen den Tiefpass-Element-Addierer 12 und den Tiefpass-Element-Integrator 13 geschaltet ist.

Dadurch ist es möglich, Sättigungseffekte auch hinsichtlich der Veränderung der Magnetstromstärke als Funktion der Änderung der Magnetspannung zu berücksichtigen. Die infolge der Sättigungseffekte eintretende Änderung der Induktivität des Elektromagneten 1 wird dann schon beim eingehenden Magnetspannungssignal einbezogen.

Hysterese-Effekte in dem Elektromagneten 1 können außerdem in dem Umwandler 22 bei der Ausgabe des Magnetfeldstärkewertes berücksichtigt werden, indem neben der Tabelle, die in dem Umwandler 22 hinterlegt ist, eine weitere Korrektur vorgenommen wird, die u.a. von der Richtung der Stromänderung abhängt.

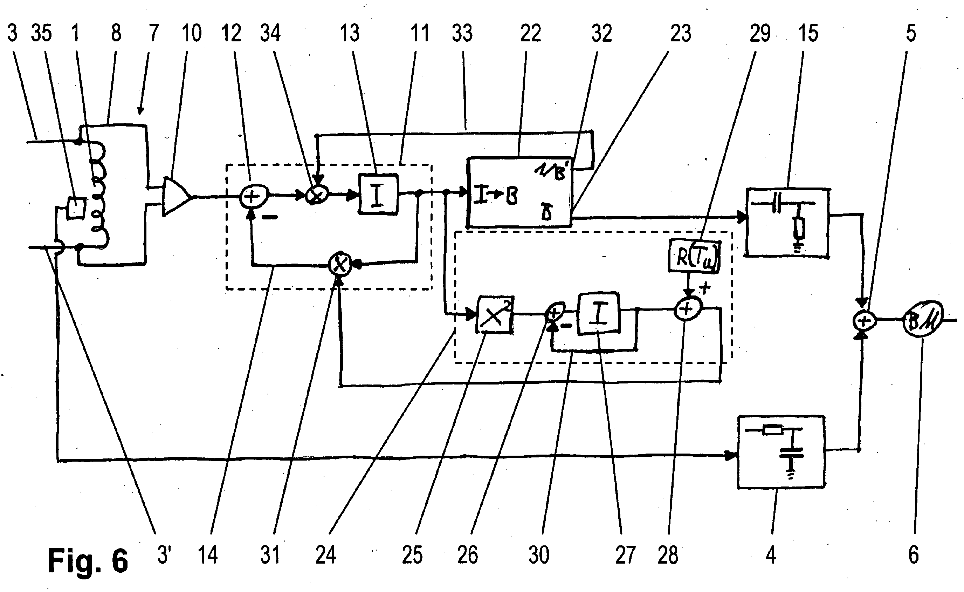

Das in Fig. 6 dargestellte Funktionsschema eines dritten Ausführungsbeispiels einer erfindungsgemäßen Einrichtung unterscheidet sich von dem in Fig. 5 dargestellten dadurch, dass statt eines DCCT eine Hall-Sonde 35 zur unmittelbaren Messung des Magnetfeldes des Elektromagneten 1 vorgesehen ist. Da das Magnetfeld in dem ersten Zweig direkt erfasst wird, ist es nicht erforderlich, das Signal des ersten Zweiges auch dem Umwandler 22 zuzuführen. Daher sind in diesem Ausführungsbeispiel sowohl der Umwandler 22 als auch die Temperaturberechnungsschaltung 24 nur in dem zweiten Zweig angeordnet.

Die Temperaturberechnungsschaltung 24 ist in diesem Fall dem Tiefpass-Element-Integrator 13 unmittelbar nachgeschaltet, hat aber einen Aufbau, der dem des zweiten Ausführungsbeispiels entspricht. Es sind ebenfalls ein Quadrierer 25, ein Rückkopplungs-Addierer 26, ein Integrator 27, ein Widerstandswert-Addierer 28, eine Widerstandswertquelle 29 und eine Rückführleitung 30 vorgesehen. Außerdem wird auch in diesem Beispiel das Ausgangssignal der Temperaturberechnungsschaltung 24 über den Multiplizierer 31 in das Tiefpass-Element 11 eingekoppelt, sodass sich die bereits im Zusammenhang mit Fig. 5 beschriebene Funktionsweise ergibt.

Der Umwandler 22, der in diesem Beispiel in dem zweiten Zweig vorgesehen ist, ist genauso ausgestaltet wie der zusammen mit Fig. 4 Beschriebene und weist einen Ausgang 23 für das Magnetfeldstärke-Signal und einen Ableitungsausgang 32 auf.

Das Magnetfeldstärkesignal des Umwandlers 22 wird über das Hochpassfilter 15 zu dem Addierer 5 geleitet, wo es mit dem Magnetfeldstärkesignal des ersten Zweigs aus der Hall-Sonde 35 und dem Tiefpassfilter 4 kombiniert und als Ausgangssignal zu dem Signalausgang 6 geleitet wird.

Neben dem Vorteil, dass das "simulierte Signal" des Tiefpass-Elements 11 ein gegenüber der Messeinrichtung in dem zweiten Zweig deutlich reduziertes Rauschen aufweist, werden bei dem zweiten und dritten Ausführungsbeispiel Temperatureffekte in dem Elektromagnet 1 sowie Sättigungseffekte und ggf. Hysterese-Effekte berücksichtigt.

Für alle Ausführungsbeispiele gilt, dass die in den vorstehend erläuterten Funktionsschemata enthaltenen Addierer 5, 12, 26, 28, Multiplizierer 31, 34, Integratoren 13, 27, Tiefpassfilter 4, 16, Hochpassfilter 15, Differenzverstärker 10 und Operationsverstärker 19 herkömmliche elektrotechnische Bauteile bzw. Baugruppen sind, die zur Ausführung der Erfindung nicht speziell angepasst sein müssen. Es kann lediglich erforderlich sein, bestimmte Parameter wie Zeitkonstanten beispielsweise in Abhängigkeit der Parameter des Elektromagneten 1 zu wählen.

Insgesamt ermöglicht die vorliegende Erfindung eine schnelle Detektion auch von geringen Abweichungen des gemessenen Magnetfeldstärke-Wertes von einem Sollwert. Dies ist insbesondere für die automatisierte Steuerung und Überwachung von Magneten an Beschleunigeranlagen relevant.

## Patentansprüche

1. Einrichtung zur Bestimmung der Magnetfeldstärke eines Elektromagneten (1), die eine schnelle Bestimmung auch von kleinen Veränderungen des Magnetfeldes erlaubt, der eine erste Zuleitung (3) und eine zweite Zuleitung (3') aufweist, mit
einer Messeinrichtung (2,35) zur Bestimmung des Magnetfeldes des Elektromagneten (1), mit einem der Messeinrichtung nachgeschalteten Tief- passfilter (4),
einem Tiefpass-Element (11), das mit der ersten Zuleitung (3) und der zweiten Zuleitung (3') verbunden ist und das angepasst ist, aus der Spannung zwischen der ersten Zuleitung (3) und der zweiten Zuleitung (3') am Ausgang des Tiefpass-Elements (11) ein Signal auszugeben, das an den zeitlichen Verlauf der Magnetfeldstärke in dem Elektromagneten (1) angenähert ist
mit einem zu dem Tiefpass-Element (11) in Reihe geschalteten Hochpassfilter (15) und
mit einem Signalausgang (6),
wobei der Ausgang des Tiefpassfilters (4) mit einem Addierer (5) verbunden ist, dessen Ausgang zu dem Signalausgang (6) führt, und
wobei der Ausgang des Hochpassfilters (15) mit dem Addierer (5) verbunden ist.

2. Einrichtung nach Anspruch 1, wobei das Tiefpass-Element (11)
einen Tiefpass-Element-Addierer (12) mit einem ersten Eingang, einem zweiten Eingang und einem Ausgang,
einen Tiefpass-Element-Integrator (13), der mit dem Ausgang des Tiefpass-Element-Addierers (12) verbunden ist, und
eine Rückführverbindung (14) aufweist,
wobei der erste Eingang des Tiefpass-Element-Addierers (12) den Eingang des Tiefpass-Elements (11) bildet,
wobei der Ausgang des Tiefpass-Element-Integrators (13) den Ausgang des Tiefpass-Elements (11) bildet und
wobei die Rückführverbindung (14) den Ausgang des Tiefpass-Element-Integrators (13) mit dem zweiten Eingang des Tiefpass-Element-Addierers (12) verbindet.

3. Einrichtung nach Anspruch 1, wobei das Tiefpass-Element (11) als Tiefpass (16) mit einem ohmschen Widerstand und einem Kondensator ausgebildet ist, dessen Grenzfrequenz an die Induktivität und den ohmschen Widerstand des Elektromagneten (1) angepasst ist.

4. Einrichtung nach Anspruch 1, wobei das Tiefpass-Element (11) einen ersten Widerstand (18),
einen Operationsverstärker (19),
einen Kondensator (20) und
einen zweiten Widerstand (21) aufweist,
wobei der erste Widerstand (18) mit dem invertierenden Eingang des Operationsverstärkers (19) verbunden ist,
wobei der Kondensator (20) zu dem invertierenden Eingang und dem Ausgang des Operationsverstärkers (19) parallel geschaltet ist und
wobei der zweite Widerstand (21) zu dem Kondensator (20) sowie zu dem invertierenden Eingang und dem Ausgang des Operationsverstärkers (19) parallel geschaltet ist.

5. Einrichtung nach einem der Ansprüche 1 bis 4, wobei eine Temperaturberechnungsschaltung (24) vorgesehen ist, um Temperaturveränderungen in dem Elektromagneten (1) zu berücksichtigen, und wobei die Temperaturberechnungssschaltung (24) mit dem Tiefpass-Element (11) verbunden ist.

6. Einrichtung nach Anspruch 5, wobei die Temperaturberechnungsschaltung (24)
einen Quadrierer (25),
einen Rückkopplungs-Addierer (26), der über seinen ersten Eingang mit dem Ausgang des Quadrierers (25) verbunden ist,
einen Integrator (27), dessen Eingang mit dem Ausgang des Rückkopplungs-Addierers (26) verbunden ist,
eine Rückführleitung (30), die den Ausgang des Integrators (27) mit dem zweiten Eingang des Rückkopplungs-Addierers (26) verbindet,
einen Widerstandswert-Addierer (28), der einen ersten Eingang, einen zweiten Eingang, der mit dem Ausgang des Integrators (27) verbunden ist, und einen Ausgang aufweist,
und eine Widerstandswertquelle (29), die ein Spannungssignal an den zweiten Eingang des Widerstandswert-Addierers (28) liefert, umfasst,
wobei in der Rückführverbindung (14) des Tiefpass-Elements (11) ein Multiplizierer (31) vorgesehen ist und
wobei der Ausgang des Widerstandswert-Addierers (28) mit dem Multiplizierer (31) verbunden ist.

7. Einrichtung nach einem der Ansprüche 1 bis 6, wobei ein Umwandler (22) vorgesehen ist, der mit dem Ausgang des Tiefpass-Elements (11) verbunden ist und der angepasst ist, ein Signal proportional zur Magnetfeldstärke in dem Elektromagneten (1) auszugeben.

8. Einrichtung nach Anspruch 7, wobei der Umwandler (22) einen Ableitungsausgang (32) aufweist, der ein Signal liefert, das proportional zum Kehrwert der Ableitung der Magnetfeldstärke im Elektromagneten (1) als Funktion des Stromes ist,
wobei zwischen dem Tiefpass-Element-Addierer (12) und dem Tiefpass-Element-Integrator (13) ein Multiplizierer (34) vorgesehen ist, dessen erster Eingang mit dem Tiefpass-Element-Addierer (12) und dessen Ausgang mit dem Tiefpass-Element-Integrator (13) verbunden ist, und
wobei der Ableitungsausgang (32) mit dem zweiten Eingang des Multiplizierers (34) verbunden ist.

9. Einrichtung nach einem der Ansprüche 1 bis 8, wobei die Messeinrichtung als Magnetfeldstärke-Messeinrichtung ausgebildet ist.

10. Einrichtung nach Anspruch 9, wobei die Magnetfeldmesseinrichtung als Hall-Sonde (35) ausgebildet ist.

11. Einrichtung nach einem der Ansprüche 1 bis 8, wobei die Messeinrichtung als Magnetstrommesseinrichtung ausgebildet ist.

12. Verfahren zur Bestimmung der Stärke des Magnetfelds eines Elektromagneten (1), das eine schnelle Bestimmung auch von kleinen Veränderungen des Magnetfeldes erlaubt,
bei dem ein erstes Signal erfasst wird, dessen Höhe ein direktes Maß für die Magnetfeldstärke des Elektromagneten (1) ist,
bei dem die über dem Elektromagneten (1) abfallende Spannung erfasst wird,
bei dem aus der erfassten Spannung ein zweites Signal erzeugt wird, wobei die erfasste Spannung Tiefpass-gefiltert wird, sodass der zeitliche Verlauf des zweiten Signals an den der Magnetfeldstärke in dem Elektromagneten (1) angenähert wird,
bei dem das erste Signal und das zweite Signal zu einem Ausgangssignal kombiniert werden und
bei dem das erste Signal und das zweite Signal gefiltert werden, sodass nur niederfrequente Anteile des ersten Signals und nur hochfrequente Anteile des zweiten Signals in das Ausgangssignal eingehen.

13. Verfahren nach Anspruch 12, wobei die Tiefpass-Filterung **dadurch** erfolgt, dass die erfasste Spannung integriert wird und
dass das integrierte Signal vor der Integration von der erfassten Spannung abgezogen wird.

14. Verfahren nach Anspruch 12 oder 13, wobei das erste Signal durch Messen der Magnetstromstärke erfasst wird.

15. Verfahren nach Anspruch 12 oder 13, wobei das erste Signal durch Messen der Magnetfeldstärke erfasst wird.

16. Verfahren nach einem der Ansprüche 12 bis 15, bei dem bei der Erzeugung des zweiten Signals die Temperaturerhöhung des Elektromagneten (1) berücksichtigt wird.

17. Verfahren nach einem der Ansprüche 12 bis 16, bei dem das zweite Signal in ein Signal proportional zur Magnetfeldstärke umgewandelt wird, wobei Sättigungs- und/oder Hystereseeffekte kompensiert werden.

## Claims

1. Device for determining the magnetic field strength of an electromagnet (1) which device allows to determine quickly even small changes of the magnetic field, the electromagnet comprising a first supply line (3) and a second supply line (3'), said device comprising:
a measurement device (2, 35) for determining the magnetic field of the electromagnet (1),
a low-pass filter (4) downstream from the measurement device,
a low-pass filter element (11) which is connected to the first supply line (3) and to the second supply line (3') and is adapted to emit a signal at the output of the low-pass filter element (11) from the voltage between the first supply line (3) and
the second supply line (3'), which signal approximates to the time profile of the magnetic field strength in the electromagnet (1),
a high-pass filter (15) connected in series with the low-pass filter element (11), and
a signal output (6),
wherein the output of the low-pass filter (4) is connected to an adder (5) the output of which leads to the signal output (6), and
wherein the output of the high-pass filter (15) is connected to the adder (5).

2. Device according to claim 1, wherein the low-pass filter element (11) comprises
a low-pass filter element adder (12) with a first input, a second input and an output,
a low-pass filter element integrator (13) which is connected to the output of the low-pass filter element adder (12), and
a feedback connection (14),
wherein the first input of the low-pass filter element adder (12) forms the input of the low-pass filter element (11),
wherein the output of the low-pass filter element integrator (13) forms the output of the low-pass filter element (11), and
wherein the feedback connection (14) connects the output of the low-pass filter element integrator (13) to the second input of the low-pass filter element adder (12).

3. Device according to claim 1, wherein the low-pass filter element (11) is in the form of a low-pass filter (16) with a resistor and a capacitor and its cut-off frequency is matched to the inductance and the resistance of the electromagnet (1).

4. Device according to claim 1, wherein the low-pass filter element (11) comprises a first resistor (18) ,
an operational amplifier (19),
a capacitor (20), and
a second resistor (21),
wherein the first resistor (18) is connected to the inverting input of the operational amplifier (19), wherein the capacitor (20) is connected in parallel with the inverting input and the output of the operational amplifier (19), and
wherein the second resistor (21) is connected in parallel with the capacitor (20) and the inverting input and the output of the operational amplifier (19).

5. Device according to any of claims 1 to 4, wherein a temperature calculation circuit (24) is provided in order to take account of temperature changes in the electromagnet (1), and wherein the temperature calculation circuit (24) is connected to the low-pass filter element (11).

6. Device according to claim 5, wherein the temperature calculation circuit (24) comprises a squaring element (25),
a feedback adder (26) which is connected via its first input to the output of the squaring element (25),
an integrator (27) whose input is connected to the output of the feedback adder (26),
a feedback line (30) which connects the output of the integrator (27) to the second input of the feedback adder (26),
a resistance adder (28) which has a first input, a second input which is connected to the output of the integrator (27), and an output,
and a resistance source (29) which passes a voltage signal to the second input of the resistance adder (28),
wherein a multiplier (31) is provided in the feedback connection (14) of the low-pass filter element (11), and
wherein the output of the resistance adder (28) is connected to the multiplier (31).

7. Device according to any of claims 1 to 6, wherein a converter (22) is provided which is connected to the output of the low-pass filter element (11) and is adapted to emit a signal proportional to the magnetic field strength in the electromagnet (1).

8. Device according to claim 7, wherein the converter (22) has a derivative output (32) which produces a signal which is proportional to the reciprocal of the derivative of the magnetic field strength in the electromagnet (1) as a function of the current, wherein a multiplier (34) is provided between the low-pass filter element adder (12) and the low-pass filter element integrator (13), the first input of the multiplier being connected to the low-pass filter element adder (12) and the output of the multiplier being connected to the low-pass filter element integrator (13), and
wherein the derivative output (32) is connected to the second input of the multiplier (34).

9. Device according to any of claims 1 to 8, wherein the measurement device is in the form of a magnetic field strength measurement device.

10. Device according to claim 9, wherein the magnetic field measurement device is in the form of a Hall probe (35).

11. Device according to one of claims 1 to 8, wherein the measurement device is in the form of a magnet current measurement device.

12. Method for determining the strength of the magnetic field of an electromagnet (1) which method allows to determine quickly even small changes of the magnetic field,
in which a first signal is recorded whose magnitude is a direct measure of the magnetic field strength of the electromagnet (1),
in which the voltage dropped across the electromagnet (1) is recorded,
in which a second signal is produced from the recorded voltage, with the recorded voltage being low-pass-filtered such that the time profile of the second signal is approximated to that of the magnetic field strength in the electromagnet (1), in which the first signal and the second signal are combined to form an output signal, and
in which the first signal and the second signal are filtered such that only low-frequency components of the first signal and only high-frequency components of the second signal are included in the output signal.

13. Method according to claim 12, wherein the low-pass filtering is carried out by integrating the recorded voltage and
by subtracting the integrated signal from the recorded voltage before integration.

14. Method according to claim 12 or 13, wherein the first signal is recorded by measuring the magnet current level.

15. Method according to claim 12 or 13, wherein the first signal is recorded by measuring the magnetic field strength.

16. Method according to any of claims 12 to 15, in which the temperature increase of the electromagnet (1) is taken into account in production of the second signal.

17. Method according to any of claims 12 to 16, in which the second signal is converted to a signal proportional to the magnetic field strength, with saturation and/or hysteresis effects being compensated for.

## Revendications

1. Dispositif servant à déterminer l'intensité du champ magnétique d'un électroaimant (1) alimenté par un premier conducteur (3) et par un second conducteur (3'), ce dispositif permettant la détermination rapide même dans le cas de faibles variations du champ, et comportant :
- un dispositif de mesure (2, 35) servant à déterminer le champ magnétique de l'électroaimant (1) et auquel est raccordé en aval un filtre passe-bas (4),
- un élément passe-bas (11) qui est relié au premier conducteur (3) et au second conducteur (3') et qui, à partir de la tension existant entre le premier conducteur (3) et le second conducteur (3'), est apte à délivrer à la sortie de l'élément passe-bas (11) un signal qui représente approximativement l'évolution dans le temps de l'intensité du champ magnétique dans l'électroaimant (1),
- un filtre passe-haut (15) relié en série à l'élément passe-bas (11),
- une sortie de signal (6)
étant précisé que la sortie de filtre passe-bas (4) est reliée à un additionneur (5) dont la sortie aboutit à la sortie de signal (6), et que la sortie du filtre passe-haut (15) est reliée à l'additionneur (5).

2. Dispositif selon la revendication 1, dans lequel l'élément passe-bas (11) présente :
- un additionneur d'élément passe-bas (12) comportant une première entrée, une seconde entrée et une sortie,
- un intégrateur d'élément passe-bas (13) qui est relié à la sortie de l'additionneur d'élément passe-bas (12), et
- une liaison de retour (14),
étant précisé que la première entrée de l'additionneur d'élément passe-bas (12) constitue l'entrée de l'élément passe-bas (11), que la sortie de l'intégrateur d'élément passe-bas (13) constitue la sortie de l'élément passe-bas (11) et que la liaison de retour (14) relie la sortie de l'intégrateur d'élément passe-bas (13) à la seconde entrée de l'additionneur d'élément passe-bas (12).

3. Dispositif selon la revendication 1, dans lequel l'élément passe-bas (11) est réalisé sous la forme d'un passe-bas (16) avec une résistance ohmique et un condensateur, dont la fréquence limite est adaptée à l'inductance et à la résistance ohmique de l'électroaimant (1).

4. Dispositif selon la revendication 1, dans lequel l'élément passe-bas (11) présente
une première résistance (18),
un amplificateur d'opération (19),
un condensateur (20)
et une seconde résistance (21),
étant précisé que la première résistance (18) est montée en parallèle avec l'entrée inverseuse de l'amplificateur d'opération (19),
que le condensateur (20) est monté en parallèle avec l'entrée inverseuse et avec la sortie de l'amplificateur d'opération (19)
et que la seconde résistance (21) est montée en parallèle avec le condensateur (20) ainsi qu'avec l'entrée inverseuse et avec la sortie de l'amplificateur d'opération (19).

5. Dispositif selon une des revendications 1 à 4, dans lequel est prévu un circuit de calcul de température (24) servant à prendre en compte les variations de température à l'intérieur de l'électroaimant (1), ce circuit de calcul de température (24) étant relié à l'élément passe-bas (11).

6. Dispositif selon la revendication 5, dans lequel le circuit de calcul de température (24) comprend :
- un quadrateur (25),
- un additionneur de rétroaction (26) qui est relié par sa première entrée à la sortie du quadrateur (25),
- un intégrateur (27) dont l'entrée est reliée à la sortie de l'additionneur de rétroaction (26),
- un conducteur de retour (30), qui relie la sortie de l'intégrateur (27) à la seconde entrée de l'additionneur de rétroaction (26),
- un additionneur de valeurs de résistance (28), qui présente une première entrée, une seconde entrée qui est reliée à la sortie de l'intégrateur (27), et une sortie,
- une source de valeurs de résistance (29) qui délivre un signal de tension à la seconde entrée de l'additionneur de valeurs de résistance (28),
étant précisé qu'un multiplicateur (31) est prévu dans la liaison retour (14) de l'élément passe-bas (11) et que la sortie de l'additionneur de valeurs de résistance (28) est reliée au multiplicateur (31).

7. Dispositif selon une des revendications 1 à 6, dans lequel est prévu un convertisseur (22) qui est relié à la sortie de l'élément passe-bas (11) et qui est adapté pour délivrer un signal proportionnel à l'intensité du champ magnétique existant dans l'électroaimant (1).

8. Dispositif selon la revendication 7, dans lequel le convertisseur (22) présente une sortie dérivée (32) délivrant un signal qui est proportionnel à l'inverse de la dérivée de l'intensité du champ magnétique dans l'électroaimant (1) en tant que fonction du courant, étant précisé qu'entre l'additionneur d'élément passe-bas (12) et l'intégrateur d'élément passe-bas (13), est prévu un multiplicateur (34) dont la première entrée est reliée à l'additionneur d'élément passe-bas (12), tandis que sa sorite est reliée à l'intégrateur d'élément passe-bas (13), la sortie de dérivée (32) étant reliée à la seconde entrée du multiplicateur (34).

9. Dispositif selon une des revendications 1 à 8, dans lequel le dispositif de mesure est un dispositif de mesure de l'intensité du champ magnétique.

10. Dispositif selon la revendication 9, dans lequel le dispositif de mesure de l'intensité du champ magnétique est une sonde à effet Hall (35).

11. Dispositif selon une des revendications 1 à 8, dans lequel le dispositif de mesure de l'intensité du champ magnétique est un dispositif de mesure de courant de l'électroaimant.

12. Procédé pour déterminer l'intensité du champ magnétique d'un électroaimant (1) permettant la détermination rapide même de petites variations du champ, selon lequel :
- est saisi un premier signal dont la hauteur est une mesure directe de l'intensité du champ magnétique de l'électroaimant (1),
- est saisie la tension qui est abaissée par l'électroaimant (1),
- à partir de la tension saisie est produit un second signal, et cette tension est filtrée par le filtre passe-bas de sorte que l'évolution dans le temps de ce deuxième signal représente approximativement celle de l'intensité du champ magnétique de l'électroaimant (1),
- le premier et le second signal sont combinés en un signal de sortie, en étant filtrés de sorte que seules les fractions à basse fréquence du premier signal et celles à haute fréquence du second signal interviennent dans le signal de sortie.

13. Procédé selon la revendication 12, selon lequel la filtration passe-bas s'effectue en intégrant la tension saisie, le signal intégré étant déclenché avant l'intégration de la tension saisie.

14. Procédé selon la revendication 12 ou 13, selon lequel le premier signal est saisi en mesurant l'intensité du courant de l'électroaimant.

15. Procédé selon la revendication 12 ou 13, selon lequel le premier signal est saisi en mesurant l'intensité du champ de l'électroaimant.

16. Procédé selon une des revendications 12 à 15, selon lequel lors de la production du second signal, l'élévation de la température de l'électroaimant (1) est prise en compte.

17. Procédé selon une des revendications 12 à 16, selon lequel le second signal est converti en un signal proportionnel à l'intensité du champ magnétique, les effets de saturation et/ou d'hystérésis étant compensés.
